# EUROPÄISCHE PATENTSCHRIFT

(11) **EP 0 242 826 B1**
(45) Veröffentlichungstag und Bekanntmachung des Hinweises auf die Patenterteilung: **03.11.1993**
(21) Anmeldenummer: 87105743.6
(22) Anmeldetag: 16.04.1987
(51) Int. Cl.: H01J 37/34

(54) **Magnetron-Zerstäubungskathode**
Cathode for magnetron sputtering
Cathode de pulvérisation magnétron

(30) Priorität: 17.04.1986 DE 3613018
(43) Veröffentlichungstag der Anmeldung: 28.10.1987
(73) Patentinhaber: dos Santos Pereira Ribeiro, Carlos Antonio, Dipl.-Ing., D-72459 Albstadt (DE)
(72) Erfinder: dos Santos Pereira Ribeiro, Carlos Antonio, Dipl.-Ing., D-72459 Albstadt (DE)
(74) Vertreter: Vogeser, Werner, Dipl.-Ing.

(56) Entgegenhaltungen:
- EP-A- 0 105 407
- DE-A- 2 707 144
- DE-A- 2 735 525
- DE-A- 3 519 907
- GB-A- 2 173 217

## Beschreibung

Die Erfindung betrifft eine Magnetron-Zerstäubungskathode der im Oberbegriff des Anspruchs 1 angegebenen Art.

Eine derartige Magnetron-Zerstäubungskathode ist Bestandteil einer Vorrichtung zur Beschichtung von Substraten, wobei das jeweilige Beschichtungsmaterial, vorliegend das Targetmaterial, aus der Gasphase auf den zu beschichtenden Substraten abgeschieden wird. Das Targetmaterial wird durch Zerstäubung in die Gasphase überführt. Bei diesem Zerstäubungsprozeß wird durch lonenbeschuß des Targets Material aus dem Target herausgeschlagen. Die für den Zerstäubungsprozeß benötigten Ionen werden üblicherweise durch Zusammenstöße von Gasatomen und Elektronen in einer Glimmentladung erzeugt und mit Hilfe eines elektrischen Feldes in das die Kathode bildende Target hinein beschleunigt. Die an geeigneter Stelle angeordneten Substrate fangen die aus dem Targetmaterial herausgeschlagenen Atome auf und werden so mit dem Targetmaterial beschichtet.

Bei der in Rede stehenden Magnetron-Zerstäubungskathode wird ein magnetisches Feld dazu verwendet, das Glimmentladungsplasma einzuschließen und damit die Bahnlänge der Elektronen zu verlängern, so daß die Zusammenstoßrate zwischen Gasatomen und Elektronen erhöht wird. Dadurch ergibt sich eine höhere Zerstäubungsausbeute als bei Vorrichtungen, die ohne magnetische Begrenzung arbeiten. Außerdem läßt sich der Zerstäubungsprozeß bei wesentlich geringerem Gasdruck ausführen.

Eine Besonderheit der eingangs genannten, aus der EP-A-0105407 bekannten Magnetron-Zerstäubungskathode besteht in der mäanderförmigen Ausgestaltung des Magnetsystems, durch das ein Entladungsbereich auf der Targetoberfläche festgelegt ist, das durch eine mäanderförmige, geschlossene Schleife gebildet ist. Durch den mäander- oder schlagenförmigen Verlauf der Eräosionszone kann praktisch eine beliebig große Targetfläche erreicht werden. Außerdem können die Magnetpole so nahe aneinandergerückt werden, daß die Targeterosion sehr gleichmäßig und wesentlich breiter verläuft als bei den bekannten kreis- oder ringförmigen Targeterosionszonen bekannter Kathoden. Die mäanderförmige Ausgestaltung des Magnetsystems führt zu dem zu einer Erhöhung des Targetnutzungsgrades und der Beschichtungsrate, da nahezu die gesamte Targetoberfläche zur Erosionszone wird. Bei dieser bekannten Magnetron-Zerstäubungskathode mit mäanderförmig ausgestaltetem Magnetsystem erfolgt die Kühlung der Targetplatte sowie des Magnetsystems dadurch, daß auch die Kühlflüssigkeit den mäanderförmigen Weg durch die Kühlkammer zurücklegt und zudem nicht direkt im Eingriff mit der Rückseite der Targetplatte steht, sondern von dieser durch eine Kupferplatte getrennt ist.

Aus der DE-A-2 707 144 ist eine Kathoden-Zerstäubungseinrichtung bekannt, bei der ein plattenförmiges Permanentmagnetsystem an der Rückseite eines plattenförmigen Trägerkörpers ohne Zwischenschaltung einer zusätzlichen Platte direkt angeordnet ist, was eine Kühlung der Targetplatte ermöglicht.

Aus der DE-A-2 735 525 ist eine Kathodenanordnung mit Targetzerstäubungsanlage bekannt, bei der ein plattenförmiger Trägerkörper eine Ausnehmung aufweist, die von der Targetplatte abdichtend abgedeckt ist, wobei die Targetplatte vollflächig gekühlt ist.

Aus der DE-A-3 519 907 ist eine Targetplatte für eine Kathodenzerstäubungseinrichtung bekannt, die entlang einer Mittellinie der zu zerstäubenden Fläche eine Befestigungsschiene aufweist, um ein Abheben der Targetplatte von der gekühlten Unterlage zu verhindern.

Die Aufgabe der vorliegenden Erfindung besteht darin, eine Magnetron-Zerstäubungskathode der eingangs genannten Art zu schaffen, die eine effiziente Kühlung der Targetplatte sowie des Magnetsystems ermöglicht.

Gelöst wird diese Aufgabe durch die kennzeichnenden Merkmale des Anspruchs 1.

Demnach besteht ein wesentlicher Aspekt der Erfindung in einem effizienten Kühlsystem, bei welchem das Kühlfluid die großflächig ausgebildete Kühlkammer im wesentlichen laminar und über den gesamten Querschnitt von einem Ende zum anderen möglichst gleichmäßig durchströmt.

Weiterhin wird durch die erfindungsgemäße Ausbildung des Kühlsystems durch Anwendung der Merkmale der Ansprüche 2 und 3 die Targetplatte praktisch vollflächig und gleichmäßig gekühlt, so daß sich dadurch Kathodenleistungen von über 30 W/cm² anstelle der bisher realisierbaren 10 bis maximal 15 W/cm² verwirklichen lassen. Durch die erfindungsgemäß vorgeschlagene Kühlfluidführung in der Kühlmittelkammer läßt sich eine im wesentlichen laminare Fluidströmung, welche sich im gesamten Bereich der Kammer einstellt, erreichen, so daß sich keine "toten" Zonen mit praktisch stillstehendem Fluid bilden können. Die laminare Kühlfluidströmung erlaubt die Anwendung eines Überdrucks für das Kühlfluid von weniger als 0,5 bar, so daß Targetverwerfungen oder Rißbildungen im Targetmaterial ausgeschlossen sind.

Die Schichtdicke des die Kühlkammer durchströmenden Fluids kann wegen der laminaren Strömungsverhältnisse relativ gering gewählt werden, vorteilhafterweise etwa 2 bis 4 mm dick, was wiederum insofern von Vorteil ist, als das plattenförmige Magnetsystem der Targetplatte sehr nahe zu liegen kommt. Durch die Plattenform des Magnetsystems kann dieses vollflächig am Kühlkammerboden anliegen, wodurch es ebenfalls durch das die Kammer durchströmende Fluid ausreichend gekühlt wird.

Aus Vorstehendem wird deutlich, daß die erfindungsgemäße Magnetron-Zerstäubungskathode mit wesentlich höherer Leistung betrieben werden kann als eine solche herkömmlicher Bauart, so daß aufgrund der wesentlich erhöhten Beschichtungsrate eine Mehrzahl von Werkstücken oder ein größeres Werkstück, als es nach dem Stand der Technik möglich wäre, gleichzeitig mit nur einer einzigen erfindungsgemäß ausgebildeten Kathode beschichtet werden kann.

Vorteilhafterweise ist im Dichtungsrandbereich von Targetplatte und plattenförmigem Trägerkörper, also im Dichtungsbereich Kühlkammer/Vakuum eine Leckdetektoreinrichtung vorgesehen, die im einfachsten Falle aus einer einzigen Durchgangsbohrung im Trägerkörper besteht, die zwischen einem äußeren und einem mit Abstand parallel dazu liegenden inneren Dichtring im Randbereich des Kühlsystems mündet, welche an eine Vakuumpumpe angeschlossen ist.

Gemäß einer weiteren vorteilhaften Ausgestaltung der Erfindung ist vorgesehen, die Targetplatte mit dem Trägerkörper mittels Klammern in Form von Schraubzwingen zusammenzuspannen. Spannvorrichtungen dieser Art gestatten die Einstellung eines geeigneten Anpreßdruckes der Targetplatte an den Trägerkörper. Da es möglich ist, die Spannschrauben der Spannvorrichtung auf der Rückseite der Targetplatte anzuordnen, also abgewandt von der zu zerstäubenden Oberfläche, werden diese nicht mit Targetmaterial beschichtet, was der Stabilisierung des Plasmas zugute kommt.

Vor allem bei großflächigen Targetplatten ist es von Vorteil, außerhalb des eigentlichen Entladungsbereiches, jedoch im Bereich der Targetmitte, Spannschrauben od.dgl. vorzusehen, um dadurch eine Aufwölbung der Targetplatte zu vermeiden.

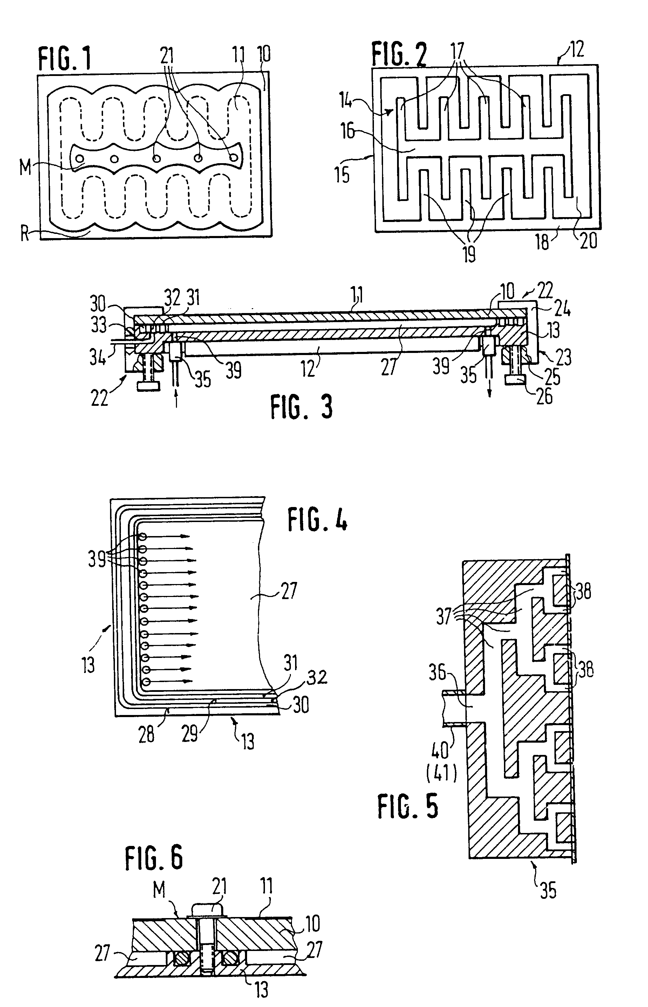

Weitere Merkmale und vorteilhafte Ausgestaltungen der erfindungsgemäß ausgebildeten Magnetron-Zerstäubungskathode gehen aus den Unteransprüchen sowie aus der nachstehenden Beschreibung eines in den Figuren 1 bis 6 der Zeichnung dargestellten, besonders bevorzugten Ausführungsbeispiels hervor. Es zeigen:
- Fig. 1: eine Aufsicht auf die mäanderförmig verlaufende Erosionszone der erfindungsgemäß ausgebildeten Zerstäubungskathode in schematischer Darstellung;
- Fig. 2: eine Aufsicht auf ein plattenförmiges Permanentmagnetsystem zur Erzeugung der mäanderförmigen Erosionszone gemäß Fig. 1;
- Fig. 3: einen Querschnitt durch die erfindungsgemäß ausgebildete Magnetron-Zerstäubungskathode;
- Fig. 4: eine Aufsicht auf den Trägerkörper der Magnetron-Zerstäubungskathode nach Fig. 3;
- Fig. 5: einen Schnitt durch ein Anschlußelement für die Zu- und Ableitung des Kühlfluids zu der Kühlmittelkammer, und
- Fig. 6: einen Schnitt durch die Targetplatte und den Trägerkörper in deren zentralem Bereich.

Die erfindungsgemäß ausgebildete Magnetron-Zerstäubungskathode besteht, wie aus den Figuren 1 bis 3 ersichtlich, aus der Targetplatte 10, aus deren Erosionszone 11 das Material zerstäubt wird, dem Magnetsystem 12 (Fig. 2 und 3) und dem zwischen diesen angeordneten plattenförmigen Trägerkörper 13.

Wie aus Fig. 2 hervorgeht, umfaßt das Magnetsystem 12 einen innenliegenden Magnetpol, den magnetischen Südpol 14, und einen äußeren Magnetpol, den magnetischen Nordpol 15. Der innenliegende Südpol 14 besteht aus einem längs der Mittellinie angeordneten Mittelbalken 16, von welchem sich die in gleichmäßigen Abständen voneinander angeordneten Zungen 17 rechtwinklig nach außen erstrecken. Der außenliegende Magnetnordpol 15 beseht aus einem rechteckigen Rahmen 18, von dessen beiden Längsseiten sich rechtwinklig die Zungen 19 nach innen erstrecken, welche jeweils so angeordnet sind, daß sie zwischen je zwei Zungen 17 des Südpols 14 liegen.

Infolge dieser Anordnung bzw. Ausbildung der beiden Magnetpole 14 und 15 erreicht man einen mäanderförmigen Verlauf des sich zwischen den Magnetpolen ausbildenden, praktisch flächendeckenden Magnetfeldes. Die beiden Magnetpole 14 und 15 sind im wesentlichen gleich stark, und zwar in der Größenordnung von einigen Millimetern bis etwa 2 cm. Außerdem sind die beiden Pole über eine plattenförmige Magnetbrücke 20 miteinander gekoppelt.

Entsprechend dem mäanderförmigen Magnetfeld ist die Erosionszone 11 ausgebildet (Fig. 1), welche den weitaus größten Teil der Targetplatte 10 abdeckt. Vom Magnetfeld nicht erfaßt ist lediglich ein schmaler, außenliegender Randbereich R und ein längs der Mittellinie liegender zentraler Bereich M, der beim Zerstäubungsprozeß nicht beeinflußt wird, so daß dortselbst die Spannschrauben 21 angeordnet sein können, mit welchen die Targetplatte 10 mit dem unter dieser liegenden Trägerkörper 13 fluiddicht verschraubt ist, wie dies in Fig. 6 dargestellt ist.

Entlang der äußeren Längskanten sind die Targetplatte 10 und der plattenförmige Trägerkörper 13 mittels einer Spannvorrichtung 22, welche aus Schraubzwingen 23 besteht, miteinander verbunden. Jede Schraubzwinge 23 besteht aus einer Profilschiene 24, in deren unterem, der Targetplatte 10 abgekehrten Schenkel 25 mehrere Spannschrauben 26 angeorndet sind, um die beiden Platten mit der notwendigen Spannung zusammenzuspannen. Auf der Vorderseite des Trägerkörpers 13 befindet sich eine rechteckige Mulde, welche die Kühlkammer 27 bildet, die vollflächig durch die Targetplatte 10 abgedeckt ist. Der Hohlraum der Kühlkammer 27 wird von einem Kühlfluid durchströmt, welches einerseits die Targetplatte 10 und andererseits die rückseitig am Trägerkörper 13 angeschlossene Magnetsystemplatte 12 kühlt.

Wie aus Fig. 3 und 4 erkennbar, befinden sich zu Dichtzwecken im Randbereich des Trägerkörpers 13 randparallel zwei Nuten 28 und 29, in welche die beiden Dichtringe 30 und 31 eingelegt sind, die bei festgespannter Targetplatte 10 einen dichten Abschluß der Kühlkammer 27 nach außen gewährleisten. Weiterhin ist eine Leckdetektoreinrichtung vorgesehen, welche aus einer zwischen den Dichtringen 30 und 31 angeordneten Nut 32, einem in diese einmündenden Verbindungskanal 33, einer Verbindungsleitung 34, einer Druckmeßvorrichtung und einer Vakuumpumpe besteht.

Die Zuführung und die Ableitung des die Kühlkammer 27 durchströmenden Kühlfluids erfolgt mittels der Anschlußelemente 35, welche an einander gegenüberliegenden Seiten und seitlich der Magnetsystemplatte 12 mit dem Trägerkörper 13 auf dessen Rückseite verbunden sind.

Wie Fig. 5 zeigt, befindet sich in den Anschlußelementen 35 eine Vielzahl von vom Eintritts- bzw. Austrittskanal 36 ausgehenden, sich verzweigenden Kanälen 37, deren Endverzweigungen 38 an den in die Kühlkammer 27 mündenden Durchtrittsöffnungen 39 im Trägerkörper 13 enden. Die Anschlußelemente 35 sind mit den Zuführungs- bzw. Abführungsleitungen 40 bzw. 41 verbunden, durch die das Kühlfluid zugeführt bzw. abgeführt wird. Durch die symmetrische Verzweigung der Kanäle 37 und die Vielzahl der in einer Reihe angeordneten Ein- bzw. Austrittsöffnungen 39 wird erreicht, daß das Kühlfluid die Kühlkammer 27 in gleichmäßigem, weitgehend laminarem Strom durchströmt. Um günstige Strömungsverhältnisse zu erhalten, sollte die lichte Höhe der Kühlkammer 27 zwischen 1 bis 10 mm, vorzugsweise jedoch 2 bis 4 mm, betragen.

## Patentansprüche

1. Magnetron-Zerstäubungskathode mit einer Targetplatte (10) aus dem zu zerstäubenden Material, welche mit einem plattenförmigen Trägerkörper (13) aus nichtmagnetischem Material verbunden ist, mit einer von einem Kühlfluid zu durchström, zwischen dem Trägerkörper (13) und der Target-Henden platte (10) angeordneten Kammer (27),welche von einer Ausnehmung im Trägerkörper (13) gebildet ist und welche ein unterhalb der Targetplatte (10) angeordnetes plattenförmiges Permanentmagnetsystem (12) aufweist, das zur Erzeugung eines mäanderförmigen Magnetfelds, welches sich im wesentlichen vollflächig und gleichmäßig über die gesamte Targetplattenfläche erstreckt, ineinander greifende Polzungen (17, 19) unterschiedlicher Polarität umfaßt, die gleichmäßig voneinander beabstandet sind und sich von einem äußeren rechteck- oder rahmenförmigen Magnetpol (15) nach innen bzw. von einem innenliegenden balkenförmigen Magnetpol (15) erstrecken, und mit an dem rechteckigen, plattenförmigen Trägerkörper (13) an zwei einander gegenüberliegenden Seiten befestigten Anschlußelementen (35), welche einerseits über Öffnungen (39) mit der von einem Kühlfluid zu durchström Kammer (27) und andererseits mit einer Kühlfluid-Henden zuführungs- bzw. -abführungsleitung (40, 41) verbunden sind, dadurch gekennzeichnet, daß die die Kammer (27) bildende Ausnehmung im Trägerkörper (13) von der Targetplatte (10) dichtend abgedeckt ist, wobei die Targetplatte (10) an der Vorderseite des Trägerkörpers (13) anliegt, an dessen Rückseite das Permanentmagnetsystem (12) anliegt, daß sich der balkenförmige Magnetpol (16) längs der Mittellinie des Permanentmagnetsystems (12) erstreckt und sich nach außen erstreckende Polzungen (17) aufweist, und daß die Anschlußelemente (35) ein sich vom Einlaß- bzw. Auslaßkanal (36) ausgehendes, sich verzweigendes Kanalsystem (37) aufweisen, dessen Endverzweigungen (38) in eine Vielzahl von in regelmäßigen Abständen voneinander angeordneten Durchtrittsöffnungen (39) in dem Trägerkörper (13) münden.

2. Magnetron-Zerstäubungskathode nach Anspruch 1, gekennzeichnet durch eine Leckdetektoreinrichtung, welche im Dichtungsrandbereich von Targetplatte (10) und Trägerörper (13) angeordnet ist.

3. Magnetron-Zerstäubungskathode nach Anspruch 2, dadurch gekennzeichnet, daß die Leckdetektoreinrichtung aus einer zwischen zwei Dichtungsringen (30, 31) liegenden Nut (32), wobei die Dichtungsringe (30, 31) parallel zueinander und entlang des Randes der Trägerplatte (13) angeordnet sind, und einem in die Nut (32) einmündenden, mit einer Vakuumleitung (34) verbundenen Kanal (33) und einer Druckmeßvorrichtung besteht.

4. Magnetron-Zerstäubungskathode nach einem der Ansprüche 1 bis 3, dadurch gekennzeichnet, daß die Targetplatte (10) mit dem plattenförmigen Trägerkörper (13) im Dichtungsrandbereich mittels einer aus Schraubzwingen (23) od.dgl. bestehenden Spannvorrichtung (22) verbunden ist.

5. Magnetron-Zerstäubungskathode nach Anspruch 4, dadurch gekennzeichnet, daß die Targetplatte (10) mit dem plattenförmigen Trägerkörper (13) im zentralen Bereich (M) zusätzlich mittels mehrerer Spannschrauben (21) verbunden ist, welche durch Bohrungen in der Targetplatte hindurch in Gewindebohrungen in dem Trägerkörper (13) eingeschraubt sind, welche sich über dem sich längs der Mittellinie liegenden Magnetpolbalken (16) befinden.

6. Magnetron-Zerstäubungskathode nach einem der Ansprüche 1 bis 5, dadurch gekennzeichnet, daß die lichte Höhe der Kühlkammer (27) zwischen 1 und 10mm, vorzugsweise etwa zwischen 2 und 4 mm beträgt.

## Claims

1. Magnetron atomizing cathode with a target plate (10) which is made of the material to be atomised and which is connected with a plate-shaped carrier body (13) of non-magnetic material, and with a chamber (27) through which a cooling fluid is to flow and which is situated between the carrier body (13) and the target plate (10) and which is formed by a recess in the carrier body (13) and whichhas a plate- shaped permanent magnet system (12) whichis situated underneath the target plate (10) and which inorder to generate a wave-form magnetic field which largely extends evenly over the entire surface of the target plate, includes pole tongues (17,19) of different polarity which engage one another and which are positioned at an even distance apart and which extend from an outer rectangular or frame-shaped magnet pole (15) towards the inside or extend from an internally situated beam-shaped magnet pole (15), and which are connected with connection elements (35) which are affixed at two opposite sides to the rectangular beam-shaped carrier body (13) and which are connected on the one hand via apertures (39) with the chamber (27) through which a cooling fluid is to flow and on the other hand with a cooling fluid feed and discharge pipe(40,41), characterized by the fact that the recess forming the chamber (27) is hermeticallycover ed in the carrier body (13)by the target plate(10), the said target plate (10)resting against the front of the carrier body (13), against the rear of which the permanent magnet system(12)rests,and that the beam-shaped magnet pole (16) extends along the medianline of the permanent magnet system(12)and has pole tongues(17)extending to wards the outside, and that the connecitng elements(35) have a ramified channel system(37) whichstarts from the inlet or outlet channel(36)and of which the end branches(38)lead into a nu mber of passage apertures(39)in the carrier body(13) which are situated at even distances from one another.

2. Magnetron atomizing cathode in accordance with Claim 1,characterized by a leakage detector device situated in the sealing edge zone of the target plate (10) and the carrier body (13).

3. Magnetron atomizing cathode in accordance with Claim 2,characterized by the fact that the leakage detector device consists of a groove(32) situated between two sealing rings(30,31), the said sealing rings(30,31) being parallel to each other and positioned along the edge of the carrier plate(13),and of a channel(33)which leads into the groove(32) and which is connected with a vacuum pipe(34),and of a pressure measuring device.

4. Magnetron atomizing cathode in accordance with one of Claims 1-3, characterized by the fact that the target plate (10)is connected with the plate-shaped carrier body (13)in the sealing edge zone by means of a clamping device (22) consisting of screw clamps (23)or the like.

5. Magnetron atomizing cathode in accordance with Claim4,characterized by the fact that the target plate (10) is additionally connected with the plate-shaped carrier body(13) in the central zone(M)by a number of straining screws (21) passing through the target plate and screwed into threaded borings in the carrier body which are situated above the beam-shaped magnet pole (16) situated along the median line.

6. Magnetron atomizing cathode in accordance with any one of Claims 1-5,characterized by the fact that the clearance height of the cooling chamber (27) is between 1 and 10 mm and preferably between approximately 2 and 4 mm.

## Revendications

1. Cathode de pulvérisation magnétron comportant une plaque cible (10) constituée par le matériau à pulvériser, qui est reliée à un support (13) en forme de plaque, constitué par un matériau non magnétique, une chambre (27) disposée entre le support (13) et la plaque cible (10), destinée à être traversée par un fluide réfrigérant et qui est formée par un évidement dans le support (13), et qui comporte un système d'aimant permanent (12) en forme de plaque disposé sous la plaque cible (10), qui, pour produire un champ magnétique en forme de méandres qui s'étend sensiblement uniformément sur toute la surface de la plaque cible, comporte des languettes polaires (17, 19) de polarité différente, qui pénètrent les unes dans les autres, qui sont à égale distance les unes des autres et qui s'étendent vers l'intérieur depuis un pôle magnétique externe (15) rectangulaire ou en forme de cadre ou depuis un pôle magnétique (16) en forme de barre situé à l'intérieur, et des éléments de raccordement (35) fixés sur deux côtés opposés sur le support (13) rectangulaire en forme de plaque, qui sont reliés d'un côté par des ouvertures (39) à la chambre (27) qui doit être traversée par un fluide réfrigérant et de l'autre côté à une conduite d'amenée ou d'évacuation de fluide réfrigérant (40,41), caractérisée en ce que l'évidement formant la chambre (27) dans le support (13) est recouvert de manière étanche par la plaque cible (10), la plaque cible (10) reposant sur le côté antérieur du support (13), sur le côté dorsal duquel repose le système d'aimant permanent (12), en ce que le pôle magnétique (16) en forme de barre s'étend sur l'axe du système d'aimant permanent (12) et comporte des languettes polaires (17) qui s'étendent vers l'extérieur, et en ce que les éléments de raccordement (35) comportent un système de canaux (37) qui se ramifie depuis le canal d'entrée ou de sortie (36) et dont les ramifications terminales (38) débouchent dans une multiplicité d'ouvertures de passage (39) situées à égale distance les unes des autres dans le support (13).

2. Cathode de pulvérisation magnétron selon la revendication 1, caractérisée par un dispositif de détection de fuites qui est prévu dans le domaine du bord d'étanchéité de la plaque cible (10) et du support (13).

3. Cathode de pulvérisation magnétron selon la revendication 2, caractérisée en ce que le dispositif de détection de fuites consiste en une rainure (32) située entre deux anneaux d'étanchéité (30, 31), les anneaux d'étanchéité (30,31) étant disposés parallèlement l'un à l'autre et le long du bord du support (13), en un canal (33) débouchant dans la rainure (32) et relié à une conduite à vide (34) et en un dispositif manométrique.

4. Cathode de pulvérisation magnétron selon l'une des revendications 1 à 3, caractérisée en ce que la plaque cible (10) est reliée au support (13) en forme de plaque dans le domaine du bord d'étanchéité au moyen d'un dispositif de serrage (22) consistant en serre-joints à collet (23) ou analogues.

5. Cathode de pulvérisation magnétron selon la revendication 4, caractérisée en ce que la plaque cible (10) est reliée en outre au support (13) en forme de plaque dans le domaine central (M) au moyen de plusieurs vis de serrage (21) qui sont vissées par des alésages de la plaque cible dans des alésages taraudés du support (13) qui se trouvent au-dessus de la barre formant pôle magnétique (16) située le long de l'axe.

6. Cathode de pulvérisation magnétron selon l'une des revendications 1 à 5, caractérisée en ce que la hauteur intérieure de la chambre de refroidissement (27) est comprise entre 1 et 10 mm, de préférence entre 2 et 4 mm environ.
